# EUROPÄISCHE PATENTSCHRIFT

(11) **EP 1 456 881 B1**
(45) Veröffentlichungstag und Bekanntmachung des Hinweises auf die Patenterteilung: **14.02.2007**
(21) Anmeldenummer: 02795010.4
(22) Anmeldetag: 16.12.2002
(51) Int. Cl.: H01L 23/544, G01R 31/316, G01R 31/26, G01R 31/27

(54) **VERFAHREN ZUM BESTIMMEN EINER ESD-/LATCH-UP-FESTIGKEIT EINER INTEGRIERTEN SCHALTUNG**
METHOD FOR DETERMINING THE ESD/LATCH-UP RESISTANCE OF AN INTEGRATED CIRCUIT
PROCEDE PERMETTANT DE DETERMINER UNE RESISTANCE D'UN CIRCUIT INTEGRE A DES DECHARGES ELECTROSTATIQUES/DECLENCHEMENTS PARASITES

(30) Priorität: 19.12.2001 DE 10162542
(43) Veröffentlichungstag der Anmeldung: 15.09.2004
(73) Patentinhaber: Infineon Technologies AG, 81669 München (DE)
(72) Erfinder: BARGSTÄDT-FRANKE, Silke, 81669 München (DE); ESMARK, Kai, 81375 München (DE); GOSSNER, Harald, 85521 Riemerling (DE); RIESS, Philipp, 80469 Muenchen (DE); STADLER, Wolfgang, 80538 München (DE); STREIBL, Martin, 85238 Petershausen (DE); WENDEL, Martin, 85662 Hohenbrunn (DE)
(74) Vertreter: Epping - Hermann - Fischer
(86) Internationale Anmeldenummer: PCT/DE2002/004599
(87) Internationale Veröffentlichungsnummer: WO 2003/052824

(56) Entgegenhaltungen:
- US-A- 5 523 252
- US-A- 5 675 260
- SANGIORGI E ET AL: "LATCH-UP IN CMOS CIRCUITS: A REVIEW" EUROPEAN TRANSACTIONS ON TELECOMMUNICATIONS AND RELATED TECHNOLOGIES, AEI, MILANO, IT, Bd. 1, Nr. 3, 1. Mai 1990 (1990-05-01), Seiten 107-119, XP000164824 ISSN: 1120-3862
- PATENT ABSTRACTS OF JAPAN vol. 018, no. 018 (P-1673), 12. Januar 1994 (1994-01-12) -& JP 05 256899 A (HITACHI LTD), 8. Oktober 1993 (1993-10-08)

## Beschreibung

Die Erfindung bezieht sich auf ein Verfahren zum Bestimmen einer ESD-/Latch-up-Festigkeit einer integrierten Schaltung.

Bei Fertigung und Handhabung einer integrierten Schaltung können elektrostatische Entladungen an den Anschlüssen der integrierten Schaltung auftreten, wobei bei Überschreitung der Belastungsgrenze des betroffenen Schaltungsteils der integrierten Schaltung Zerstörungen auftreten. Zum Schutz vor elektrostatischen Entladungen (ESD: Electro-Static Discharge) enthält daher eine integrierte Schaltung in der Regel zumindest eine ESD-Schutzeinrichtung. Um die ESD-Festigkeit der integrierten Schaltung zu bestimmen, werden die auf einem Wafer prozessierten integrierten Schaltungen vereinzelt und von diesen werden einzelne ausgewählt und in ein Gehäuse aufgebaut und danach in einem speziellen ESD-Testgerät vermessen. Aufgrund des notwendigen Aufbaus der integrierten Schaltungen und aufgrund der komplexen Prüfmethodik sind Zeiten von mehreren Tagen bis Wochen notwendig, um die ESD-Festigkeit anhand der integrierten Schaltungen bestimmen zu können.

Ferner dürfen belastete integrierte Schaltungen nicht mehr an Kunden weitergegeben werden, und oft werden die belasteten Schaltungen bei der Bestimmung der ESD-Festigkeit zerstört, so daß hohe Kosten entstehen. Da die Meßbedingungen (hohe Ströme im Amperebereich und Pulsdauer im Nanosekundenbereich) weitab der Standardbetriebsbedingungen der integrierten Schaltungen liegen, werden zur Messung spezielle (teuere und schwierig zu bedienende) Meßgeräte benötigt.

Auch die Latch-up-Festigkeit der integrierten Schaltung (als Latch-up wird das Zünden eines parasitären Thyristors verstanden) muß mit großem zeitlichen Aufwand untersucht werden, da die integrierte Schaltung vereinzelt, aufgebaut und vermessen werden muß. Ferner sind die vermessenen Schaltungen wiederum in der Regel nicht mehr verwendbar.

Das Dokument Sangiori et al.: "Latch-up in CMOS Circuits: a Review", European Transactions on Telecommunications and Related Technologies, AEI, Milano, Vol.1, Nr. 3, Seiten 337-349 beschreibt physikalische Grundlagen von Latch-up bei CMOS Schaltkreisen und Möglichkeiten zur Messung von Latch-up Spannungen. In der Zusammenfassung zur japanischen Patentanmeldung 04053268 ist eine Technik zur Berechnung einer Latch-up Charakteristik eines Halbleiterbauteils dargestellt.

Da mit den beschriebenen Verfahren immer nur einzelne integrierte Schaltungen der laufenden Produktion untersucht werden können, können die Meßergebnisse unter Umständen nicht repräsentativ sein. Insbesondere lassen sich Ergebnisse einer integrierten Schaltung nicht auf andere integrierte Schaltungen übertragen. Damit ist auch keine Aussage über die ESD-Festigkeit der Technologie möglich. Selbst wenn die Meßergebnisse repräsentativ sind und festgestellt wird, daß die ESD-/Latch-up-Festigkeit nicht ausreichend ist, besteht die Schwierigkeit, daß inzwischen (während der Meßzeit) die Fertigung weitergelaufen ist und somit sehr viele Ausschußprodukte erzeugt wurden. Des weiteren ist es auch äußerst schwierig festzustellen, warum die ESD-/Latch-up-Festigkeit nicht ausreichend war, welche Prozeßparameter dafür verantwortlich sind. Dies erfordert häufig weitere sehr komplexe Untersuchungen, wodurch der Zeitaufwand und die Kosten weiter steigen.

In dem Dokument US 5,523,252 ist ein Verfahren zur Bestimmung der elektrostatischen Eigenschaften eines integrierten Schaltkreises angegeben. Dabei ist ein Test-Bauteil vorgesehen und es wird die Leistung gemessen, die benötigt wird, um das Test-Bauteil elektrostatisch zu zerstören. Die Leistung wird dabei schrittweise bis zur Zerstörung erhöht.

Aufgabe der Erfindung ist es, ein Verfahren zum Bestimmen einer ESD-/Latch-up-Festigkeit einer integrierten Schaltung zur Verfügung zu stellen, mit dem die eingangs beschriebenen Schwierigkeiten so gut wie vollständig behoben sind.

Erfindungsgemäß wird die Aufgabe durch ein Verfahren zum Bestimmen einer ESD-Festigkeit und/oder einer Latch-up-Festigkeit einer integrierten Schaltung gelöst mit den Merkmalen des Patentanspruchs 1.

Durch dieses Verfahren wird vorteilhaft erreicht, daß nicht die integrierte Schaltung selbst, sondern eine Teststruktur gemessen wird, so daß durch die Messung die integrierte Schaltung nicht beeinträchtigt oder sogar zerstört wird. Es wird also eine indirekte Bestimmung der ESD-/Latch-up-Festigkeit der integrierten Schaltung durchgeführt. Auch kann die Teststruktur so gewählt werden, daß man nicht nur feststellt, ob eine gewünschte ESD-/Latch-up-Festigkeit vorliegt oder nicht, sondern auch, falls die gewünschte ESD-/Latch-up-Festigkeit nicht vorliegt, warum dies der Fall ist.

Somit kann durch das erfindungsgemäße Verfahren anhand von einfach zu messenden Technologieparametern die ESD-/Latch-up-Festigkeit bestimmt werden.

Des weiteren muß auch nicht die gesamte ESD- bzw. Latch-up-Kennlinie bei der Messung durchgefahren werden, sondern es werden nur einzelne, die entsprechende Kennlinie kennzeichnende Kennwerte aus einfach zu bestimmenden Meßwerten abgeleitet, die bei der Messung an der Teststruktur (und nicht durch Messung an der integrierten Schaltung) gewonnen werden. Es müssen dabei auch nur punktuelle Messungen an der Teststruktur durchgeführt werden. Dadurch läßt sich die notwendige Messung äußerst schnell ausführen, wodurch eine größere Anzahl von integrierten Schaltungen bezüglich ihrer ESD-/ Latch-up-Festigkeit untersucht werden können. Es ist sogar möglich, eine laufende Prozeßüberwachung durchzuführen. Es werden also nicht mehr einzelne fertige Produkte bzw. integrierte Schaltungen getestet, sondern es wird eine effektive Prozeßüberwachung, die durchaus mehrere unterschiedliche Produkte einer Technologie umfassen kann, durchgeführt.

Beim erfindungsgemäßen Verfahren wird die Teststruktur mit einem Testelement hergestellt, an dem im Meßschritt mehrere der Parameter gemessen werden. Dadurch läßt sich der Platzbedarf der Teststruktur verringern, wodurch auf dem Wafer, auf dem die integrierte Schaltung und die Teststruktur hergestellt werden, mehr Platz für die integrierte Schaltung vorhanden ist.

Die integrierte Schaltung und die Teststruktur werden auf demselben Wafer hergestellt. Eine bevorzugte Weiterbildung des erfindungsgemäßen Verfahrens besteht darin, daß das Messen vor einem Vereinzeln der integrierten Schaltung durchgeführt wird. Somit erfolgt die Messung der Teststruktur noch auf Waferebene, so daß bereits zu diesem Zeitpunkt definitiv festgestellt werden kann, ob die erforderliche ESD-/Latch-up-Festigkeit vorliegt. Falls sie nicht vorliegt, kann die integrierte Schaltung gleich als Ausschuß gekennzeichnet werden und es müssen nicht mehr die nachfolgenden Fertigungsschritte, wie beispielsweise das Vereinzeln (z. B. Heraussägen) und das Bonden durchgeführt werden. Dadurch können Kosten eingespart werden. Auch kann eine Lieferung von integrierten Schaltungen sicher vermieden werden, die eine bestimmte, vorher definierte ESD-Festigkeit nicht erreichen, und die ansonsten in sicherheitsrelevanten Bereichen (z. B. in der Automobilindustrie, insbesondere für Airbag-Steuerungen) eingesetzt werden würden.

Insbesondere kann die Messung auf Waferebene schon dann durchgeführt werden, wenn die Teststruktur schon fertiggestellt ist, aber noch nicht alle Prozeßschritte, die der Wafer zu durchlaufen hat, erfolgt sind. Es kann also mit dem erfindungsgemäßen Verfahren eine zeitlich sehr frühe Prüfung auf ESD-/Latch-up-Festigkeit durchgeführt werden, wodurch nachfolgende Fertigungsschritte, falls die ESD-/Latch-up-Festigkeit ungenügend ist, und damit auch Kosten sowie Zeit eingespart werden können.

Ferner ist es auch möglich, die Bestimmung der ESD-/Latch-up-Festigkeit der integrierten Schaltung zusammen mit der in der Halbleiterfertigung üblichen Prozeßüberwachung mittels PCM-Messungen (PCM = Process Control Monitor) durchzuführen. Dabei können auch die schon vorhandenen PCM-Tester eingesetzt werden, so daß das erfindungsgemäße Verfahren leicht in den Fertigungsprozeß von integrierten Schaltungen eingebunden werden kann (bevorzugt im Rahmen der PCM-Überwachung).

Ferner können beim erfindungsgemäßen Verfahren mehrere integrierte Schaltungen hergestellt werden, wobei dann die Teststruktur bevorzugt zwischen den integrierten Schaltungen gebildet wird. Dadurch wird effektiv der zwischen den integrierten Schaltungen vorhandene Platz, der beispielsweise zum Vereinzeln der integrierten Schaltung notwendig ist, genutzt. Auch wird dadurch die Teststruktur in unmittelbarer Nähe der integrierten Schaltung gefertigt, dessen ESD-/Latch-up-Festigkeit überprüft werden soll, so daß eine äußerst exakte Bestimmung der Festigkeit ermöglicht wird, da sich beispielsweise Schwankungen von Prozeßparametern oder veränderte Prozeßführungen in gleicher Weise auf die integrierte Schaltung und die Teststruktur auswirken.

Eine Weiterbildung des erfindungsgemäßen Verfahrens besteht darin, daß mindestens einer der Bereiche ein einseitig offener Bereich ist. Dadurch läßt sich besonders schnell überprüfen, ob der Kennwert in dem ihm zugeordneten Bereich liegt. Es muß lediglich überprüft werden, ob der Kennwert einen Grenzwert über- oder unterschreitet. Damit läßt sich der Prüfschritt einerseits leicht implementieren und andererseits sehr schnell durchführen.

Beim erfindungsgemäßen Verfahren kann zum Messen von zumindest einem der Parameter einem Testelement der Teststruktur eine Gleichspannung oder ein Gleichstrom eingeprägt und dabei der Wert des einen Parameters ermittelt werden. Dadurch muß nur ein einfaches Gleichstrom- bzw. Gleichspannungs-Meßverfahren durchgeführt werden, was schneller durchführbar und einfacher handhabbar ist als beispielsweise die bei der Bestimmung der ESD-Festigkeit bisher eingesetzten Meßverfahren mit Hochstrompulsern, die zur Messung Pulse mit einer Pulsdauer von 100 ns und einem Strom von größer 1,5 A erzeugen. Diese Gleichstrom- bzw. Gleichspannungsmessung kann beispielsweise mit einem herkömmlichen PCM-Tester durchgeführt werden, so daß sich das erfindungsgemäße Verfahren leicht implementieren und in die Prozeßüberwachung einbinden läßt.

Ferner kann beim erfindungsgemäßen Verfahren die Teststruktur mit mehreren Testelementen hergestellt werden, wobei dann im Meßschritt an den mehreren Testelementen gleichzeitig gemessen wird. Dies führt zu einer weiteren Erhöhung der Meßgeschwindigkeit, wodurch die durch die Messung bedingte Verzögerung bei der Fertigung der integrierten Schaltung kleiner wird. Dadurch läßt sich der Durchsatz bei der Fertigung erhöhen.

Insbesondere kann beim erfindungsgemäßen Verfahren die integrierte Schaltung mit einer ESD-Schutzeinrichtung und einem zu schützenden Schaltkreis (z. B. ein aktiver und/oder passiver Schaltkreis) sowie die Teststruktur mit einem der ESD-Schutzeinrichtung zugeordneten ESD-Testelement und einem dem Schaltkreis (z. B. ein aktiver und/oder passiver Schaltkreis) zugeordneten Schaltkreis-Testelement hergestellt werden, wobei anhand der abgeleiteten Kennwerte ermittelt wird, ob eine vorbestimmte Beziehung zwischen einer ESD-Kennlinie der ESD-Schutzeinrichtung und einer ESD-Kennlinie des Schaltkreises (z. B. ein aktiver und/oder passiver Schaltkreis) vorliegt. Damit kann eine indirekte Bestimmung der ESD-Kennlinie der ESD-Schutzeinrichtung und der ESD-Kennlinie des Schaltkreises (z. B. ein aktiver und/oder passiver Schaltkreis) durchgeführt und insbesondere auch ein Vergleich der beiden Kennlinien durchgeführt werden, wodurch man äußerst exakte Aussagen über die ESD-Festigkeit und auch über möglicherweise kritische Kennlinien-Beziehungen treffen kann.

Des weiteren kann die ESD-Schutzeinrichtung einen Schutztransistor aufweisen und das ESD-Testelement einen entsprechenden Testtransistor aufweisen, wobei der Testtransistor mit kleineren Abmessungen gefertigt ist als der Schutztransistor. Dies führt einerseits zu einer Platzersparnis, da insbesondere die ESD-Schutzeinrichtungen einen großen Platzbedarf aufweisen, und andererseits können mit deutlich geringeren Stromwerten als im tatsächlichen ESD-Fall die gleichen Stromdichten im Schutztransistor erzeugt werden. Dadurch lassen sich in einfacher Art exakte Aussagen insbesondere über das Hochstromverhalten der ESD-Schutzeinrichtung gewinnen.

Bei dem erfindungsgemäßen Verfahren zum Bestimmen der ESD-Festigkeit werden insbesondere solche Kennwerte bestimmt, die einen Leckstrom, eine ESD-Triggerspannung, eine ESD-Haltespannung, einen differentiellen ESD-Hochstromwiderstand und eine ESD-Strombelastbarkeit der ESD-Schutzeinrichtung und/ oder der zu schützenden integrierten Schaltung kennzeichnen. Damit sind die relevantesten Punkte in der ESD-Kennlinie erfaßt, wodurch sich zutreffende Aussagen über die ESD-Festigkeit ableiten lassen.

Des weiteren können beim erfindungsgemäßen Verfahren für verschieden Bauelement-Klassen (beispielsweise mit unterschiedlichen maximalen Versorgungsspannungen, z. B. 1,2 und 3,3 Volt) verschiedene Testelemente in der Teststruktur gebildet werden. Damit können mittels einer Teststruktur unterschiedliche Spannungsklassen hinsichtlich ESD-/Latch-up-Festigkeit überwacht werden.

Insbesondere kann beim erfindungsgemäßen Verfahren die Teststruktur mit einem Thyristor hergestellt werden, wobei anhand der abgeleiteten Kennwerte ermittelt wird, ob eine Triggerspannung und ein Triggerstrom eines parasitären Thyristors der integrierten Schaltung jeweils vorbestimmte Mindestwerte übersteigen. Als Thyristor der Teststruktur wird bevorzugt ein solcher hergestellt, der für den ungünstigsten parasitären Thyristor der integrierten Schaltung repräsentativ ist. Dadurch kann anhand einer Messung am Thyristor der Teststruktur auf die Triggerspannung und den Triggerstrom des parasitären Thyristors der integrierten Schaltung rückgeschlossen werden.

Insbesondere können beim erfindungsgemäßen Verfahren solche Kennwerte bestimmt werden, die eine Latch-up-Triggerspannung, einen Latch-up-Triggerstrom, eine Latch-up-Haltespannung und/ oder einen Latch-up-Haltestrom kennzeichnen. Dadurch sind die relevantesten Punkte der Latch-up-Kennlinie erfaßt, wodurch sehr exakte Aussagen über die Latch-up-Festigkeit getroffen werden können.

Ferner kann beim erfindungsgemäßen Verfahren in der Teststruktur ein Durchbruch-Testelement hergestellt werden, wobei anhand der ermittelten Kennwerte bestimmt wird, ob eine Durchbruchspannung eines parasitären Elements der integrierten Schaltung einen vorbestimmten Wert übersteigt. Dies ist insbesondere für die ESD-Festigkeit relevant, da die Spannung bei der (maximalen) ESD-Strombelastbarkeit kleiner sein sollte als die Durchbruchspannung des parasitären Elements. Somit kann die ESD-/Latch-up-Festigkeit der integrierten Schaltung sehr genau ermittelt werden.

Die Erfindung soll nachfolgend beispielshalber anhand der Zeichnungen noch näher erläutert werden. Es zeigen:
- Figur 1: eine schematische Darstellung eines Abschnitts einer integrierten Schaltung;
- Figur 2: ein Diagramm mit zwei ESD-Kennlinien;
- Figur 3: eine schematische Darstellung eines ESD-Testelements;
- Figur 4: ein Diagramm mit einer Latch-up-Kennlinie und
- Figur 5: eine schematische Darstellung eines Latch-up-Testelements.

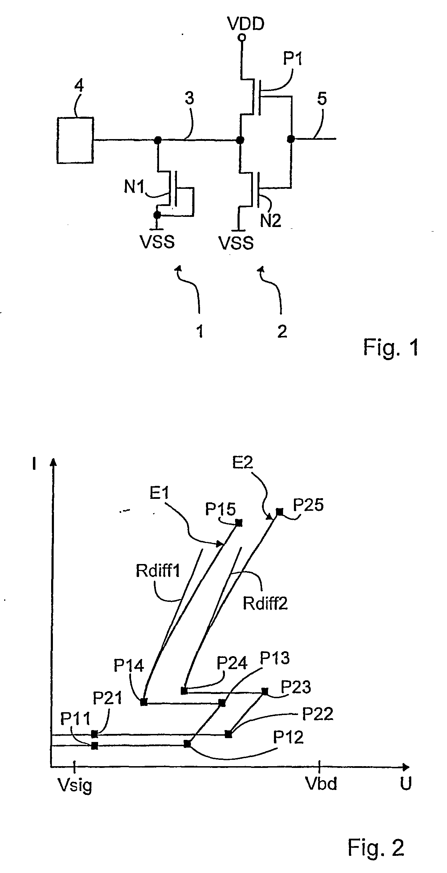

In Figur 1 ist schematisch ein Beispiel für einen Teil einer integrierten Schaltung gezeigt, dessen ESD-/Latch-up-Festigkeit bestimmt werden soll. Der in Figur 1 gezeigte Teil der integrierten Schaltung umfaßt eine ESD-Schutzeinrichtung 1 sowie einen zu schützenden Schaltkreis 2 (z. B. aktiver und/ oder passiver Schaltkreis), die beide über eine Ausgabeleitung 3 mit einer Kontaktfläche 4 verbunden sind.

Die ESD-Schutzeinrichtung 1 enthält in dem hier gezeigten Beispiel einen n-Kanal Feldeffekttransistor N1, dessen Drain-Anschluß mit der Ausgabeleitung 3 verbunden ist und dessen Gate- und Source-Anschluß zusammen auf Masse VSS liegen. Der aktive Schaltkreis 2 ist in dem hier gezeigten Beispiel ein Ausgangstreiber der einen p-Kanal Feldeffekttransistor P1 und einen n-Kanal Feldeffekttransistor N2 aufweist, die zwischen Versorgungsspannung VDD und Masse VSS in Reihe geschaltet sind und deren Gate-Anschlüsse miteinander verbunden und über eine Leitung 5, die in die integrierte Schaltung führt, ansteuerbar sind.

In Figur 2 sind schematisch eine gewünschte ESD-Kennlinie E1 der ESD-Schutzeinrichtung 1 und eine gewünschte ESD-Kennlinie E2 des aktiven Schaltkreises 2 dargestellt, wobei entlang der x-Achse die Spannung U und entlang der y-Achse der Strom I aufgetragen sind.

Um den aktiven Schaltkreis 2 gegenüber einem ESD-Ereignis zu schützen, muß die Strom-Spannungs-ESD-Kennlinie E1 der ESD-Schutzeinrichtung 1 oberhalb der maximalen Signalspannung Vsig (= VDD) für einen gegebenen Spannungswert, der sich aus dem ESD-Strom ableitet, stets einen größeren Stromwert aufweisen als die Strom-Spannungs-ESD-Kennlinie E2 des zu schützenden Schaltkreises 2, so daß der Strompuls eines ESD-Ereignisses hauptsächlich durch die ESD-Schutzeinrichtung 1 abgeführt wird. Weiterhin darf der Leckstrom der ESD-Schutzeinrichtung 1 im normalen Betrieb bei Spannungen bis zur maximalen Signalspannung Vsig nicht zu hoch sein, da sonst die ESD-Schutzeinrichtung 1 den normalen Betrieb des aktiven Schaltkreises 2 zu stark verschlechtern würde.

Zum Beurteilen dieser Bedingungen müssen die ESD-Kennlinien E1, E2 aber gar nicht direkt, exakt und insbesondere auch nicht komplett gemessen werden. Beide ESD-Kennlinien E1 und E2 können nämlich mittels Strom-/Spannungswerten einiger ausgezeichneter Punkte zumindest so weit beschrieben werden, daß sicher beurteilt werden kann, ob die ESD-Schutzeinrichtung 1 den gewünschten ESD-Schutz des aktiven Schaltkreises 2 gewährleistet.

Ausgezeichnete Punkte der ESD-Kennlinien E1 und E2 sind insbesondere der Leckstrom Ileak1, Ileak2 beim Anlegen der maximalen Signalspannung Vsig (Punkte P11, P21), die Durchbruchspannung Vbd1, Vbd2 (Punkte P12, P22), die Triggerspannung Vt11, Vt12 (Punkte P13, P23), die Haltespannung Vh1, Vh2 (Punkte P14, P24), der differentielle Hochstromwiderstand Rdiff1, Rdiff2 sowie die maximale Strombelastbarkeit It21, It22 (Punkte P15, P25).

Jedes Schutzelement (z. B. Diode, Thyristor oder auch komplexere Schutzschaltungen) kann durch eine solche Kennlinie E1 beschrieben werden. Bei einer Diode fällt z. B. die Trigger- und Haltespannung mit der Durchbruchspannung zusammen.

Um nun die ESD- und/oder Latch-up-Festigkeit (bzw. ESD-/ Latch-up-Festigkeit) der integrierten Schaltung bestimmen zu können, wird zusammen mit der integrierten Schaltung eine Teststruktur mittels derselben Prozeßschritte auf demselben Wafer hergestellt. An der Teststruktur werden dann elektrische Parameter gemessen, wobei aus den gemessenen Parameterwerten bevorzugt die oben angegebenen Kennwerte der ESD-Kennlinien E1 und E2 abgeleitet werden. Somit ist ein Messen an der integrierten Schaltung selbst nicht notwendig.

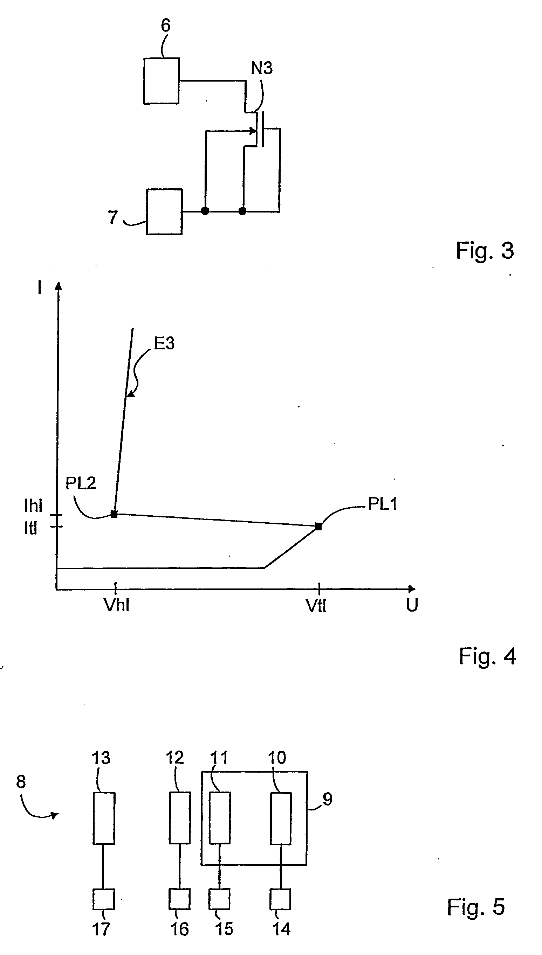

In Figur 3 ist beispielhaft ein Element der Teststruktur gezeigt, das zur Bestimmung der ESD-Festigkeit der ESD-Schutzeinrichtung 1 verwendet wird. Es handelt sich dabei um einen n-Kanal MOS-Feldeffekttransistor N3, dessen Drain-Anschluß über eine Anschlußfläche 6 kontaktierbar ist und dessen Gate-, Source- und Bulk-Anschluß miteinander verbunden sowie über eine Anschlußfläche 7 kontaktierbar sind. Da ESD-Schutzeinrichtungen in der Regel relativ groß sind, ist es bevorzugt, daß das ESD-Testelement kleiner hergestellt wird. Dadurch wird die Größe der Teststruktur verringert und es können dieselben Stromdichten mit kleineren Spannungen erzeugt werden.

In dem hier beschriebenen Beispiel einer 0,13 *µ*m-Technologie mit einer Versorgungsspannung von 1,2 Volt weist das ESD-Testelement N3 ein W/L-Verhältnis von 100 µm/0,12 µm (W/L entspricht Gate-Breite/Gate-Länge) auf, während der n-Kanal MOS-Feldeffekttransistor N1 der ESD-Schutzeinrichtung 1 ein W/L-Verhältnis von 200 µm/0,12 µm aufweist.

Im folgenden werden insbesondere unter Bezugnahme auf das in Figur 3 gezeigte ESD-Testelement verschiedene Messungen beschrieben, aus denen die obigen Kennwerte der ESD-Kennlinie E1 abgeleitet werden können.

So wird der Leckstrom Ileak1 dadurch bestimmt, daß die Anschlußfläche 7 auf Masse VSS gelegt wird und daß an die Anschlußfläche 6 eine Spannung angelegt wird, die etwas höher als die maximale Signalspannung Vsig ist. In dem hier beschriebenen Beispiel beträgt die maximale Signalspannung Vsig 1,2 Volt und es wird in etwa ein 10 % höherer Wert angelegt. Der dabei zwischen beiden Anschlußflächen 6 und 7 fließende Strom wird bestimmt. Der gemessene Stromwert muß unterhalb eines vorgegeben Stromwertes liegen, der beispielsweise 1 *µ*A sein kann, damit der Leckstrom klein genug und somit akzeptabel ist für eine integrierte Schaltung.

Als nächstes wird die Triggerspannung Vt11 abgeleitet. Dazu wird dem n-Kanal Feldeffekttransistor N3 eine Spannung eingeprägt, die etwas größer als die vorgegebene Triggerspannung ist. Bei dem hier beschriebenen Beispiel beträgt die vorgegebene Triggerspannung etwa 5,7 V und es wird eine um etwa 10 % höhere Spannung eingeprägt, so daß die eingeprägte Spannung etwa 6,3 Volt beträgt. Es wird der dabei fließende Strom gemessen, wobei die Strommessung mit einer Strombegrenzung durchgeführt wird. Die Strombegrenzung ist so gewählt, daß sie etwas größer ist als der Strom, der unmittelbar nach dem Zünden (Sprung von Punkt P13 zu Punkt P14) des ESD-Testelementes fließt, also der Strom am Punkt P14. Dieser beträgt etwa 1 mA, so daß die Strombegrenzung beispielsweise auf 10 mA eingestellt werden kann.

Bei der Messung wird nun festgestellt, ob die Strombegrenzung anspricht oder nicht. Wenn sie anspricht, wurde das ESD-Testelement gezündet und es kann daraus abgeleitet werden, daß die vorbestimmte Triggerspannung Vt11 klein genug ist. Wenn die Strombegrenzung nicht anspricht, wird daraus abgeleitet, daß die Triggerspannung Vt11 größer als die eingeprägte Spannung sein muß, was nicht gewünscht ist und was dazu führen kann, daß die ESD-Schutzeinrichtung 1 nicht den geplanten ESD-Schutz gewährleistet. Somit ist es äußerst einfach, die sonst schwierig zu messende Triggerspannung zu bestimmen.

Zum Ableiten der Haltespannung Vh1 wird dem ESD-Testelement ein Strom eingeprägt, der etwas größer ist als der Triggerstrom It11 (am Punkt P13). Bei einem Triggerstrom It11 von beispielsweise 1 mA kann ein Strom von 10 mA eingeprägt werden. Die dabei abfallende Spannung entspricht dann in etwa der Haltespannung Vh1. Der Fehler, den man dadurch macht, daß man einen größeren Strom als den Triggerstrom einprägt, kann man beispielsweise dadurch vermindern, daß man mittels des differentiellen Widerstandes Rdiff1 den Spannungsanteil aufgrund des höheren eingeprägten Stromes (höher als der Triggerstromwert am Punkt P13) von der gemessenen Spannung abzieht.

Die so bestimmte Haltespannung Vh1 muß größer als die maximale Signalspannung Vsig sein, wobei man bevorzugt noch einen gewissen Sicherheitsabstand zu der Signalspannung Vsig fordert. Ferner muß auch die Haltespannung Vh1 kleiner als die Haltespannung Vh2 (Punkt P24) des aktiven Schaltkreises 2 sein, damit die in Figur 2 gezeigte Beziehung der beiden ESD-Kennlinien E1, E2 gewährleistet ist. Die Ermittlung der Kennwerte für den aktiven Schaltkreis 2 werden nachfolgend beschrieben.

Zur Ableitung des differentiellen Widerstandes Rdiff1 ist in der Teststruktur ein entsprechendes Diffusionsgebiet gebildet (nicht gezeigt), an dem der Flächenwiderstand gemessen wird. Sofern die Technologie beispielsweise Silizid- oder Salizid-Schichten zur Reduzierung des Widerstandes umfaßt, ist das Diffusionsgebiet ohne solche Schichten gebildet, da man den Widerstand der Diffusionsschicht messen möchte.

Mit dem gemessenen Flächenwiderstand wird der entsprechende differentielle Hochstromwiderstand Rdiff1 der ESD-Schutzeinrichtung 1 gemäß ihren tatsächlichen Abmessungen berechnet. Der differentielle Hochstromwiderstand Rdiff1 muß so gewählt sein, daß die Spannung im Punkt P15 der ESD-Kennlinie E1 kleiner ist als die Durchbruchspannung Vpara von parasitären Elementen, wie z. B. eine Gateoxid-Durchbruchspannung, so daß im ESD-Fall eine Zerstörung von diesen Elementen verhindert wird.

Für die Ermittlung der maximalen Strombelastbarkeit (Strom It21 im Punkt P15; bei noch höheren Strömen kommt es zur thermischen Zerstörung des Elements) enthält die Teststruktur einen weiteren n-Kanal Feldeffekttransistor (nicht gezeigt), der in gleicher Weise wie der in Figur 3 gezeigte beschaltet ist, wobei aber sein W/L-Verhältnis 10 µm/0,12 µm beträgt, so daß mit einem relativ geringen Gleichstrom (z. B. 50 bis 60 mA) die Stromdichte, die in der ESD-Schutzeinrichtung 1 im ESD-Fall vorliegt, im weiteren n-Kanal Feldeffekttransistor erzeugt werden kann.

Zum Ableiten des Stromes It21 wird dem weiteren n-Kanal Feldeffekttransistor ein Gleichstrom von etwa 50 bis 60 mA kurzzeitig eingeprägt (im Millisekundenbereich). Danach wird an diesem n-Kanal Feldeffekttransistor wiederum eine Leckstrommessung bei einer z. B. um 10 % höheren Spannung als die maximale Signalspannung durchgeführt. Als Kriterium zur Bewertung des gemessenen Leckstroms kann man beispielsweise festlegen, daß der Leckstrom kleiner sein muß als ein vorgegebener maximaler Leckstrom von beispielsweise 1 µA. Man kann auch das Kriterium wählen, daß der gemessene Leckstrom kleiner sein soll als der Leckstrom des n-Kanal Feldeffekttransistor N3 bzw. kleiner als ein Vielfaches davon.

Zur Ableitung der Durchbruchspannung Vpara (Figur 2) von den parasitären Elementen der integrierten Schaltung (bevorzugt von parasitären Elementen im Bereich der ESD-Schutzeinrichtung) sind in der Teststruktur weitere Testelemente enthalten, bei denen beispielsweise zwei Metall-Leiter voneinander beabstandet und isoliert sind. Es wird eine Spannung in Höhe der Durchbruchspannung Vpara eingeprägt und gemessen, ob Strom fließt. Wenn Strom fließt, hat ein Durchbruch stattgefunden und die Durchbruchspannung Vpara ist zu niedrig. Wenn kein Strom fließt, liegt eine ausreichend hohe Spannungsfestigkeit vor. In dieser Art können noch weitere Testelemente für weitere Durchbruchspannungsmessungen vorgesehen sein (z. B. für einen Gateoxiddurchbruch).

Für den aktiven Schaltkreis 2 sind entsprechende Teststrukturen wie für die ESD-Schutzeinrichtung 1 vorgesehen und es werden entsprechende Messungen durchgeführt, so daß auch für die ESD-Kennlinie E2 die relevanten Werte bestimmt werden können.

Da bei den beschriebenen Messungen lediglich ein Gleichstrom bzw. eine Gleichspannung eingeprägt werden muß, können die Messungen sehr schnell durchgeführt werden. Damit ist eine Überwachung jedes gefertigten Wafers möglich, so daß die ESD-Festigkeit laufend (z. B. im Rahmen der üblichen Prozeßüberwachung) kontrolliert werden kann.

Natürlich kann die ESD-Schutzschaltung 1 mehr Elemente als den bisher beschriebenen n-Kanal Transistor N1 aufweisen. So kann die ESD-Schutzschaltung weitere Transistoren, Dioden und Widerstände umfassen. In diesem Fall kann es notwendig sein, daß in der Teststruktur weitere Testelemente vorgesehen werden. Jedoch wird die grundlegende Idee beibehalten, anhand der durch Messungen ermittelten Parameterwerten die ESD-Festigkeit der integrierten Schaltung zu bewerten. Damit kann eine Prozeßüberwachung der ESD-Festigkeit mit einfachsten und schnell durchzuführenden Messungen realisiert werden.

Die Latch-up-Festigkeit der integrierten Schaltung kann wie die ESD-Festigkeit anhand einer Teststruktur bestimmt werden, die zusammen mit der integrierten Schaltung mit denselben Schritten auf einem einzigen Wafer hergestellt wird.

In Figur 4 ist eine typische Latch-up-Kennlinie E3 gezeigt, aus der sich entnehmen läßt, daß bei einer Triggerspannung Vtl und einem Triggerstrom Itl die Latch-up-Struktur zündet (Punkt PL1), auf eine Haltespannung Vhl mit einem Haltestrom Ihl zurückspringt (Punkt PL2) und dann niederohmig stark ansteigt. Die relevanten Punkte sind hier die Punkte PL1 und PL2 (insbesondere hier Triggerstrom Itl und Haltespannung Vhl).

Zur Ermittlung dieser Kennwerte wird in der Teststruktur ein in Figur 5 schematisch dargestelltes Vierpol-Bauelement 8 gefertigt, das den ungünstigsten Fall eines parasitären Thyristors in der integrierten Schaltung repräsentiert. Das Vierpol-Bauelement 8 besteht aus einer typischen Thyristorstruktur: In einer n-Wanne 9 sind ein Wannenanschluß 10 und ein p⁺-Gebiet 11 vorgesehen und zur n-Wanne 9 benachbart sind ein n⁺-Gebiet 12 und ein p-Anschluß 13 gebildet. Der Wannenanschluß 10 und der p-Anschluß 13 sowie die n⁺- und p⁺-Gebiete 11, 12 sind jeweils mit einer Anschlußfläche 14, 15, 16, 17 verbunden, über die variabel Spannungen und Ströme eingeprägt und gemessen werden können.

Zur Ermittlung der Triggerspannung Vtl der Kennlinie E3 (bei negativer Injektion) wird an den Anschlußflächen 14 und 15 jeweils die Versorgungsspannung VDD angelegt und wird die Anschlußfläche 17 mit Masse VSS verbunden. An der Anschlußfläche 16 wird eine Spannung angelegt, die etwa 10 % geringer als die gewünschte Triggerspannung Vtl ist, wobei die Triggerspannung etwa VDD + 1 Volt beträgt. Der dabei zwischen den Anschlußflächen 14 und 17 fließende Strom wird gemessen, wobei bevorzugt eine Strombegrenzung eingestellt ist. Die Strombegrenzung ist auf einen Wert eingestellt, der etwas größer als der Haltestrom Ihl ist. Wenn nun bei der Messung die Strombegrenzung anschlägt, ist die Triggerspannung Vtl zu niedrig. Wenn die Strombegrenzung nicht anschlägt, liegt die Triggerspannung Vtl hoch genug. Damit läßt sich einfach durch Auswerten, ob die Strombegrenzung aktiv wurde oder nicht, ableiten, daß die Triggerspannung im zulässigen Bereich liegt oder nicht.

Für positive Injektion verläuft das Verfahren entsprechend, die Einprägung erfolgt dabei in die Anschlußfläche 15, wobei die eingeprägte Spannung etwa 10% geringer als die gewünschte Triggerspannung Vtl (-1V) liegt und somit etwa -0,9V beträgt. Die Anschlußflächen 16 und 17 sind dabei mit Masse VSS beaufschlagt und an der Anschlußfläche 14 liegt VDD an.

Zur Messung des Triggerstroms Itl wird im Unterschied zur obigen Messung eine Spannung V an der Anschlußfläche 16 (negative Injektion) oder 15 (positive Injektion) eingeprägt, die etwas größer als die Triggerspannung Vtl ist und der dabei auftretende Strom wird gemessen. Man mißt also den Strom im Rücksprungpfad von PL1 nach PL2 und beendet dann die Messung, so daß der Triggerstrom Itl bestimmt werden kann. Dieser gemessene Triggerstrom Itl muß größer als eine minimale Triggerschwelle sein, damit eine ausreichende Latch-up-Festigkeit gegeben ist.

Ferner wird.noch die Haltespannung Vhl ermittelt; indem ein Strom über die Anschlußfläche 16 (negative Injektion) oder 15 (positive Injektion) eingeprägt wird, der minimal größer ist als der Triggerstrom Itl. Die Beaufschlagung der restlichen Anschlußflächen ist gleich wie bei beiden obigen Messungen an der Vierpol-Struktur 8. Die dabei auftretende Spannung muß größer sein als eine minimale Haltespannung, die bevorzugt größer als die maximale Signalspannung Vsig ist.

Damit läßt sich auch die Latch-up-Festigkeit der integrierten Schaltung anhand einiger kurzer Messungen an einer Teststruktur ermitteln, so daß eine laufende Prozeßüberwachung durchgeführt werden kann.

Natürlich können noch weitere Teststrukturen (insbesondere Vierpol-Strukturen mit anderen Abmessungen) vorgesehen sein, um weitere kritische parasitäre Thyristoren in der integrierten Schaltung hinsichtlich ihrer Latch-up-Festigkeit zu überwachen. Es kann aber auch nur die beschriebene Vierpol-Struktur 8 einmal oder mehrmals (mit nahezu denselben Abmessungen) vorgesehen sein, um die Latch-up-Festigkeit für verschiedene Bauelemente-Klassen (z. B. mit unterschiedlicher maximaler Versorgungsspannung) zu ermitteln und laufend zu überwachen.

## Patentansprüche

1. Verfahren zum Bestimmen einer ESD-Festigkeit und/oder einer Latch-up-Festigkeit einer integrierten Schaltung, mit den Schritten:
Gemeinsames Herstellen einer integrierten Schaltung (1, 2) und einer Teststruktur (N3) auf demselben Wafer mittels derselben Prozeßschritte,
Messen mehrerer elektrischer Parameter an der Teststruktur (N3), wobei zum Messen der Parameter einem Testelement der Teststruktur (N3) jeweils eine ausgezeichnete Gleichspannung oder ein ausgezeichneter Gleichstrom eingeprägt und dabei der Wert der jeweiligen Parameter durch Gleichstrom- oder Gleichspannungsmessung ermittelt wird,
**gekennzeichnet durch** die Schnitte:
Ableiten von Kennwerten aus den gemessenen Parameterwerten, wobei die Kennwerte eine der integrierten Schaltung (1, 2) zugeordnete ESD- bzw. Latch-up-Kennlinie kennzeichnen,
Vorbestimmen von Bereichen, wobei die Bereiche so gewählt sind, daß eine gewünschte ESD-Festigkeit und/oder Latch-up-Festigkeit vorliegt, wenn Kennwerte jeweils innerhalb ihres Bereiches liegen,
und Prüfen, ob die abgeleiteten Kennwerte jeweils innerhalb des ihnen zugeordneten vorbestimmten Bereiches liegen.

2. Verfahren nach Anspruch 1, bei dem das Messen vor Vereinzeln der integrierten Schaltung (1, 2) durchgeführt wird.

3. Verfahren nach einem der obigen Ansprüche, bei dem mehrere integrierte Schaltungen hergestellt werden und die Teststruktur (N3) zwischen den integrierten Schaltungen gebildet wird.

4. Verfahren nach einem der obigen Ansprüche, bei dem mindestens einer der Bereiche ein einseitig offener Bereich ist.

5. Verfahren nach einem der obigen Ansprüche, bei dem die Teststruktur mit mehreren Testelementen hergestellt und im Meßschritt an den Testelementen gleichzeitig gemessen wird.

6. Verfahren nach einem der obigen Ansprüche, bei dem die integrierte Schaltung (1, 2) mit einer ESD-Schutzeinrichtung (1) und einem zu schützenden Schaltkreis (2) sowie die Teststruktur mit einem der ESD-Schutzeinrichtung (1) zugeordneten ESD-Testelement (N3) und einem dem Schaltkreis (2) zugeordneten Schaltkreis-Testelement hergestellt werden, wobei anhand der abgeleiteten Kennwerte ermittelt wird, ob eine vorbestimmte Beziehung zwischen einer ESD-Kennlinie (E1) der ESD-Schutzeinrichtung (1) und einer ESD-Kennlinie (E2) des Schaltkreises (2) vorliegt.

7. Verfahren nach Anspruch 6, bei dem die ESD-Schutzeinrichtung einen Schutztransistor (N1) und das ESD-Testelement ein Testtransistor (N3) aufweist, wobei der Testtransistor (N3) kleiner ist als der Schutztransistor.

8. Verfahren nach Anspruch 6 oder 7, bei dem solche Kennwerte bestimmt werden, die eine ESD-Triggerspannung, eine ESD-Haltespannung, einen differentiellen ESD-Hochstromwiderstand oder eine ESD-Strombelastbarkeit der ESD-Schutzeinrichtung und/oder dem zu schützenden aktiven Schaltkreis kennzeichnen.

9. Verfahren nach einem der obigen Ansprüche, bei dem für verschiedene Bauelemente-Klassen verschiedene Testelemente in der Teststruktur gebildet werden.

10. Verfahren nach einem der obigen Ansprüche, bei dem die Teststruktur mit einem Thyristor hergestellt wird, wobei anhand der abgeleiteten Kennwerte ermittelt wird, ob eine Triggerspannung und ein Triggerstrom eines parasitären Thyristors der integrierten Schaltung jeweils vorbestimmte Mindestwerte übersteigen

11. Verfahren nach einem der obigen Ansprüche, bei dem solche Kennwerte bestimmt werden, die eine Latch-up-Triggerspannung, einen Latch-up-Triggerstrom, eine Latch-up-Haltespannung und/oder einen Latch-up-Haltestrom kennzeichnen.

12. Verfahren nach einem der obigen Ansprüche, bei dem in der Teststruktur ein Durchbruch-Testelement hergestellt wird, wobei anhand der ermittelten Kennwerte bestimmt wird, ob eine Durchbruchspannung eines parasitären Elements der integrierten Schaltung einen vorbestimmten Wert übersteigt.

## Claims

1. Method for determining an ESD strength and/or a latch-up strength of an integrated circuit, having the following steps:
joint production of an integrated circuit (1, 2) and a test structure (N3) on the same wafer by means of the same process steps,
measurement of a plurality of electrical parameters at the test structure (N3), a respective distinguished DC voltage or a distinguished DC current being impressed on a test element of the test structure (N3) for the purpose of measuring the parameters and the value of the respective parameter in this case being determined by DC current or DC voltage measurement, **characterized by** the steps:
derivation of characteristic values from the measured parameter values, the characteristic values characterizing an ESD or latch-up characteristic curve assigned to the integrated circuit (1, 2),
redetermination of ranges, the ranges being chosen such that a desired ESD strength and/or latch-up strength is present if the characteristic values in each case lie within their range, and testing whether the derived characteristic values in each case lie within the predetermined range assigned to them.

2. The method as claimed in claim 1, in which the measurement is carried out before the singulation of the integrated circuit (1, 2).

3. The method as claimed in one of the preceding claims, in which a plurality of integrated circuits are produced and the test structure (N3) is formed between the integrated circuits.

4. The method as claimed in one of the preceding claims, in which at least one of the regions is a region that is open on one side.

5. The method as claimed in one of the preceding claims, in which the test structure is produced with a plurality of test elements and is measured simultaneously in the measurement step at the test elements.

6. The method as claimed in one of the preceding claims, in which the integrated circuit (1, 2) is produced with an ESD protection device (1) and a circuit (2) to be protected and the test structure is produced with an ESD test element (N3) assigned to the ESD protection device (1) and a circuit test element assigned to the circuit (2), the characteristic values derived being used to determine whether there is a predetermined relationship between an ESD characteristic curve (E1) of the ESD protection device (1) and an ESD characteristic curve (E2) of the circuit (2).

7. The method as claimed in claim 6, in which the ESD protection device has a protection transistor (N1) and the ESD test element has a test transistor (N3) the test transistor (N3) being smaller than the protection transistor.

8. The method as claimed in claim 6 or 7 in which those characteristic values are determined which characterize an ESD trigger voltage, an ESD holding voltage, a differential ESD high-current resistance or an ESD current-carrying capacity of the ESD protection device and/or the active circuit to be protected.

9. The method as claimed in one of the preceding claims, in which different test elements are formed for different component classes in the test structure.

10. The method as claimed in one of the preceding claims, in which the test structure is produced with a thyristor, the characteristic values derived being used to determine whether a trigger voltage and a trigger current of a parasitic thyristor of the integrated circuit in each case exceed predetermined minimum values.

11. The method as claimed in one of the preceding claims, in which those characteristic values are determined which characterize a latch-up trigger voltage, a latch-up trigger current, a latch-up holding voltage and/or a latch-up holding current.

12. The method as claimed in one of the preceding claims, in which a breakdown test element is produced in the test structure, the characteristic values determined being used to determine whether a breakdown voltage of a parasitic element of the integrated circuit exceeds a predetermined value.

## Revendications

1. Procédé de détermination d'une résistance ESD et/ou d'une résistance latch-up d'un circuit intégré, comprenant les stades dans lesquels :
on fabrique conjointement un circuit (1, 2) intégré et une structure (N3) de test sur la même tranche au moyen des mêmes stades opératoires ;
on mesure plusieurs paramètres électriques sur la structure (N3) de test en appliquant, pour la mesure des paramètres à un élément de test de la structure (N3) de test, respectivement, une tension continue remarquable ou un courant continu remarquable et on détermine la valeur du paramètre respectif en mesurant le courant continu ou la tension continue ;
**caractérisé par** les stades dans lesquels :
on déduit, des valeurs caractéristiques des valeurs de paramètres mesurées, les valeurs caractéristiques caractérisant une courbe caractéristique ESD ou latch-up associée au circuit (1, 2) intégré ;
on détermine à l'avance des domaines en les choisissant de façon à ce qu'il y ait une résistance ESD et/ou une résistance latch-up souhaitée lorsque des valeurs caractéristiques se trouvent, respectivement, à l'intérieur de son domaine ;
et on contrôle si les valeurs caractéristiques déduites se trouvent, respectivement, à l'intérieur du domaine déterminé à l'avance, qui leur est associé.

2. Procédé suivant la revendication 1, dans lequel on effectue la mesure avant l'individualisation du circuit (1, 2) intégré.

3. Procédé suivant l'une des revendications ci-dessus, dans lequel on fabrique plusieurs circuits intégrés et on forme la structure (N3) de test entre les circuits intégrés.

4. Procédé suivant l'une des revendications ci-dessus, dans lequel au moins l'un des domaines est un domaine ouvert d'un côté.

5. Procédé suivant l'une des revendications ci-dessus, dans lequel on fabrique la structure de test avec plusieurs éléments de test et, au stade de mesure, on effectue la mesure simultanément sur les éléments de test.

6. Procédé suivant l'une des revendications ci-dessus, dans lequel on fabrique le circuit (1, 2) intégré ayant un dispositif ESD (1) et un circuit (2) à protéger ainsi que la structure de test ayant un élément (N3) de test ESD associé au dispositif de protection ESD (1) et un élément de test de circuit associé au circuit (2), dans lequel on détermine au moyen des valeurs caractéristiques déduites s'il y a une relation déterminée à l'avance entre la courbe caractéristique ESD (E1) du dispositif (1) de protection ESD et une courbe caractéristique ESD (E2) du circuit (2).

7. Procédé suivant la revendication 6, dans lequel le dispositif de protection ESD a un transistor (N1) de protection et l'élément de test ESD a un transistor (N3) de test, le transistor (N3) de test étant plus petit que le transistor de protection.

8. Procédé suivant la revendication 6 ou 7, dans lequel on détermine des valeurs caractéristiques qui caractérisent une tension de déclenchement ESD, une tension de maintien ESD, une résistance de courant ohmique ESD différentielle ou une aptitude à supporter du courant ESD du dispositif de protection ESD et/ou du circuit actif à protéger.

9. Procédé suivant l'une des revendications ci-dessus, dans lequel on forme pour des classes de composants différents des éléments de test différents dans la structure de test.

10. Procédé suivant l'une des revendications ci-dessus, dans lequel on fabrique la structure de test avec un thyristor, dans lequel on détermine au moyen des valeurs caractéristiques déduites si une tension de déclenchement et un courant de déclenchement d'un thyristor parasite du circuit intégré dépassent, respectivement, des valeurs minimums déterminées à l'avance.

11. Procédé suivant l'une des revendications ci-dessus, dans lequel on détermine des valeurs caractéristiques qui caractérisent une tension de déclenchement de latch-up, un courant de déclenchement de latch-up, une tension de maintien de latch-up et/ou un courant de maintien de latch-up.

12. Procédé suivant l'une des revendications ci-dessus, dans lequel on fabrique dans la structure de test un élément de test de claquage dans lequel on détermine au moyen des valeurs caractéristiques déterminées si une tension de claquage d'un élément parasite du circuit intégré dépasse une valeur déterminée à l'avance.
